# EUROPÄISCHE PATENTANMELDUNG

(11) **EP 1 988 569 A2**
(43) Veröffentlichungstag der Anmeldung: **05.11.2008**
(21) Anmeldenummer: 07008553.5
(22) Anmeldetag: 26.04.2007
(51) Int. Cl.: H01L 21/60, H01L 21/607, H01L 23/49, B23K 20/10

(54) **Verfahren zum Herstellen eines Anschlusskontaktes an einem Halbleiterbauelement für die Leistungselektronik und elektronisches Bauteil mit einem auf diese Weise an einem Halbleiterbauelement hergestellten Anschlusskontakt**

(71) Anmelder: SIEMENS AKTIENGESELLSCHAFT, 80333 München (DE)
(72) Erfinder: Birner, Martin, 92242 Hirschau (DE); Kreutzer, Rainer, 92637 Weiden (DE); Wöllmer, Heinz, Dr., 92260 Ammerthal (DE)

(57) **Zusammenfassung**

Bei einem Verfahren zum Herstellen eines Anschlusskontaktes an einem Halbleiterbauelement (2) für die Leistungselektronik wird das Halbleiterbauelement (2) auf zumindest einer seiner Flachseiten (8, 12) mit einem Reibschweißverfahren mit einem metallischem Kontaktelement (22) verschweißt.

## Beschreibung

Die Erfindung bezieht sich auf ein Verfahren zum Herstellen eines Anschlusskontaktes an einem Halbleiterbauelement für die Leistungselektronik. Die Erfindung bezieht sich außerdem auf ein elektronisches Bauteil mit einem Halbleiterbauelement, das mit einem Anschlusskontakt versehen ist.

Halbleiterbauelemente für die Leistungselektronik sind in der Regel als flache Plättchen ausgebildet, die auf plattenförmigen Trägersubstraten angeordnet sind. Als Trägersubstrate werden häufig sogenannte DCB-(Direct Copper Bonded)-Trägersubstrate verwendet, die aus einem keramischen Isolator bestehen, der auf einer Flachseite mit einer metallischen Schicht, in der Regel aus Kupfer Cu, versehen ist. Die Halbleiterbauelemente werden mit einer ihrer Flachseiten auf die metallische Schicht des Trägersubstrats gelötet. Auf seiner gegenüberliegenden Flachseite muss das Halbleiterbauelement ebenfalls mit einem elektrischen Anschlusskontakt versehen werden, an dem ein hoher, durch das Halbleiterbauelement senkrecht zu seinen Flachseiten fließender Laststrom abgegriffen werden kann (Lastanschluss). Das Schalten bzw. Steuern dieses Laststromes erfolgt über einen Gate- oder Steueranschluss am Halbleiterbauelement. Der Anschluss für den Laststrom (Lastanschluss) und der Anschluss für den Steuerstrom (Steueranschluss) sind dabei im Allgemeinen elektrisch voneinander getrennt.

Um große Lastströme bei möglichst geringer Verlustleistung am Übergang zwischen Halbleiterbauelement und Anschlusskontakt führen zu können, ist es notwendig, dass die Anschlusskontakte für den Laststrom einen möglichst geringen Übergangswiderstand zum Halbleiterbauelement haben, um die elektrische Verlustleistung am Übergang und damit die thermische Belastung des Halbleiterbauelementes zu reduzieren.

Ein geringer Übergangswiderstand kann auf der dem DCB-Trägersubstrat zugewandten Flachseite des Halbleiterbauelementes realisiert werden, indem dieses flächig auf das metallisierte DCB-Trägersubstrat aufgelötet wird. Zum Herstellen des Lastenanschlusses auf der dem DCB-Trägersubstrat gegenüberliegenden Flachseite des Halbleiterbauelementes sind im Stand der Technik verschiedene Verfahren bekannt. Bei dem aus der DE 197 19 703 A1 bekannten Leistungshalbleitermodul ist eine Bondverbindung mit einer Mehrzahl von mit dem Halbleiterbauelement kontaktierten Bonddrähten vorgesehen, die eine Verbindung mit einem massiven Anschlusselement herstellen. Aus der WO 03/030247 A2 ist eine alternative Technologie bekannt, bei der in einem ersten Schritt auf das Halbleiterbauelement eine Kunststofffolie auflaminiert wird, in die anschließend Öffnungen eingebracht werden, so dass bei einem nachfolgenden Beschichten mit einem elektrisch leitendem Material an diesen Öffnungen eine elektrische Kontaktierung hergestellt wird, die eine große Kontaktfläche aufweisen kann. Alternativ hierzu ist es auch bekannt, einen metallischen Anschlussbügel oder -stift direkt mit dem Halbleiterbauelement zu verlöten.

Auch für die Kontaktierung des Steueranschlusses (Gatekontaktierung) können prinzipiell die gleichen Anschlussarten verwendet werden, wobei die häufigste Art der Gatekontaktierung das Kontaktieren mit einem Bonddraht ist.

Der Erfindung liegt nun die Aufgabe zugrunde, ein Verfahren zum Herstellen eines Anschlusskontaktes an einer elektrischen Kontaktfläche eines auf einem Substrat angeordneten Halbleiterbauelements für die Leistungselektronik anzugeben, mit dem eine elektrische Verbindung zum Halbleiterbauelement möglich ist, die eine hohe Stabilität, eine hohe Stromtragfähigkeit und einen geringen Übergangswiderstand aufweist. Außerdem liegt der Erfindung die Aufgabe zugrunde, ein elektronisches Bauteil mit einem Halbleiterbauelement anzugeben, das einen auf diese Weise hergestellten Anschlusskontakt aufweist.

Hinsichtlich des Verfahrens wird die Aufgabe gemäß der Erfindung gelöst mit den Merkmalen des Patentanspruches 1. Gemäß diesen Merkmalen wird beim Herstellen eines Anschlusskontaktes an einem Halbleiterbauelement für die Leistungselektronik das Halbleiterbauelement an zumindest einer seiner Flachseiten mit einem Reibschweißverfahren mit einem metallischen Kontaktelement verschweißt.

Da der Anschlusskontakt durch ein unmittelbar mit dem Halbleiterbauelement stoffschlüssig verbundenes massives metallischen Kontaktelement erfolgt, ergibt sich eine besonders platzsparende Bauweise. Darüber hinaus ist eine hohe Strombelastbarkeit möglich, da durch das metallische Kontaktelement eine große Kontaktfläche und somit auch ein geringer Übergangswiderstand realisiert werden kann. Außerdem kann über das metallische Kontaktelement, das vorzugsweise aus Kupfer Cu besteht, die im Halbleiterbauelement erzeugte Wärme besser abgeführt werden. Ein weiterer Vorteil besteht darin, dass es sich bei einem Reibschweißverfahren um ein Fertigungsverfahren handelt, das rationell und kostengünstig durchgeführt werden kann.

Unter unmittelbarer stoffschlüssiger Verbindung im Sinne der vorliegenden Anmeldung ist auch eine Ausführungsform zu verstehen, bei der das Halbleiterbauelement an seiner zu kontaktierenden Flachseite vor dem Herstellen der Reibschweißverbindung mit dem Kontaktelement eine dünne, als Kontaktfläche dienende metallische Kontaktschicht aufweist.

Das Verfahren ist besonders für die Herstellung eines Anschlusskontaktes bei einem Halbleiterbauelement geeignet, das mit einer seiner Flachseiten auf einem Trägersubstrat angeordnet ist, und bei dem das metallische Kontaktelement mit dem Halbleiterbauelement auf seiner vom Trägersubstrat abgewandten Flachseite verschweißt wird.

In einer vorteilhaften Ausgestaltung der Erfindung ist als Kontaktelement ein zylindrischer Kontaktstift vorgesehen, der eine ringförmig umlaufende Schulter aufweist, mit der er auf das Halbleiterbauelement aufgesetzt wird, und die mit einem Rotations-Reibschweißverfahren mit dem Halbleiterbauelement verschweißt wird. Auf diese Weise ist eine fertigungstechnisch besonders einfache und sichere Kontaktierung des Kontaktelements mit dem Halbleiterbauelement realisierbar.

Als Reibschweißverfahren dient vorzugsweise ein Ultraschallschweißverfahren, mit dem besonders kurze Fertigungszeiten möglich sind.

Eine besonders platzsparende und gut strom- und wärmeleitende Anordnung liegt vor, wenn das Halbleiterbauelement auf einem DCB-Trägersubstrat angeordnet und mit diesem verlötet ist. Auf diese Weise ist auch eine großflächige Kontaktierung auf der Unterseite, d.h. auf der dem Trägersubstrat zugewandten Flachseite des Halbleiterbauelements möglich.

Bezüglich des elektronischen Bauteils wird die Aufgabe gemäß der Erfindung gelöst mit den Merkmalen des Patentanspruches 6, deren Vorteile sinngemäß den zum Patentanspruch 1 genannten Vorteilen entsprechen. Vorteilhafte Ausgestaltungen des elektronischen Bauteils sind in den dem Patentanspruch 6 nachgeordneten Unteransprüchen angegeben.

Zur weiteren Erläuterung der Erfindung wird auf die Ausführungsbeispiele der Zeichnung verwiesen. Es zeigen:
- FIG 1: ein mit einem Anschlusskontakt gemäß der Erfindung versehenes Halbleiterbauelement in einer schematischen Schnittdarstellung,
- FIG 2: ein zum Herstellen des Anschlusskontaktes gemäß der Erfindung geeignetes Reibschweißwerkzeug in einer vereinfachten perspektivischen Darstellung,
- FIG 3 bis 6: jeweils vorteilhafte Ausgestaltungen eines gemäß der Erfindung hergestellten Anschlusskontaktes in einer schematischen Schnittdarstellung,
- FIG 7 bis 9: jeweils alternative Möglichkeiten für eine weiterführende Kontaktierung des Kontaktelements mit einem Anschlussleiter.

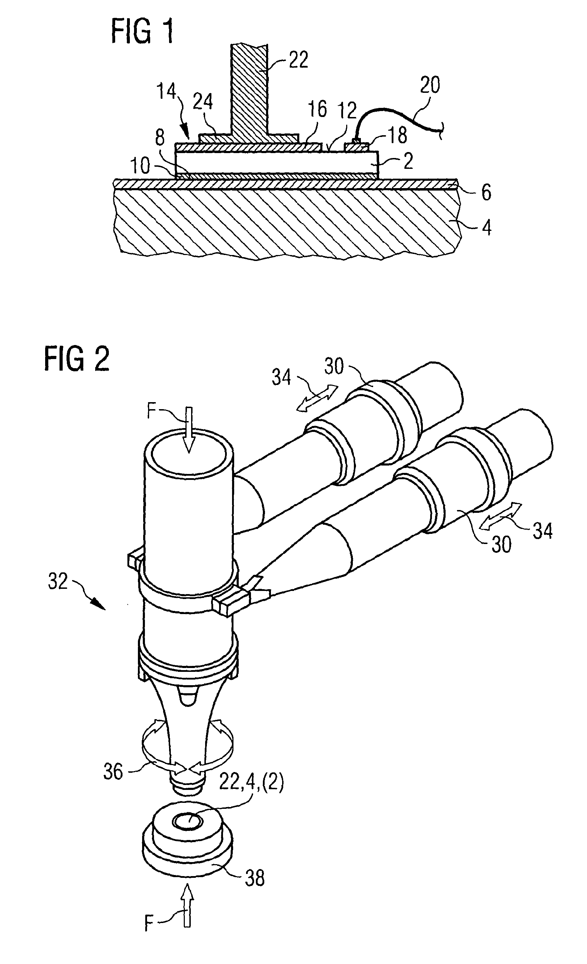

Gemäß FIG 1 ist ein Halbleiterbauelement 2, insbesondere ein Leistungs-Halbleiterbauelement, beispielsweise ein IGBT oder ein Thyristor, auf einem Trägersubstrat 4 angeordnet. Bei dem Trägersubstrat 4 handelt es sich um ein keramisches DCB-Trägersubstrat auf der Basis von Aluminiumoxid Al₂O₃ oder Aluminiumnitrit AlN, das zumindest auf seiner dem Halbleiterbauelement 2 zugewandten Flachseite mit einer vorzugsweise aus Kupfer Cu bestehenden metallischen Schicht 6 versehen ist.

Das Halbleiterbauelement 2 ist mit seiner dem Trägersubstrat 4 zugewandten Flachseite 8 - seiner Unterseite - mit dem Trägersubstrat 4 über eine dünne Lötschicht 10 großflächig verlötet. Auf seiner dem Trägersubstrat 4 abgewandten Flachseite 12 - die Oberseite - ist das Halbleiterbauelement 2 zumindest auf einem Teil seiner Fläche mit einer metallischen Schicht 14 versehen, die im Ausführungsbeispiel zwei elektrisch voneinander getrennte Kontaktzonen 16 und 18 bildet, von denen eine für den Lastanschluss und die andere für den Steueranschluss vorgesehen ist. Im Ausführungsbeispiel ist die für den Steueranschluss vorgesehene Kontaktzone 18 mit einem Bonddraht 20 kontaktiert. Die für den Lastanschluss vorgesehene Kontaktzone 16 ist elektrisch mit einem Kontaktelement 22 verbunden, das im Beispiel durch einen zylindrischen Kontaktstift gebildet wird, der an einen seiner Stirnseiten eine ringförmig umlaufende Schulter 24 aufweist, mit der er in der Kontaktzone 16 auf dem Halbleiterbauelement 2 aufsitzt und stoffschlüssig über ein Reibschweißverfahren mit diesem verbunden, d.h. verschweißt ist. Der zylindrische Kontaktstift ist mit seiner Zylinderachse senkrecht zu den Flachseiten des Halbleiterbauelementes 2 angeordnet, so dass sich eine besonders platzsparende Ausführungsform ergibt.

FIG 2 zeigt eine insbesondere für die Herstellung einer Reibschweißverbindung zwischen einem zylindrischen Teil und einem Werkstück geeignete Reibschweißvorrichtung, im Beispiel eine Ultraschall-Torsions-Schweißvorrichtung in einer schematischen Perspektivdarstellung. Eine solche Ultraschall-Torsions-Schweißvorrichtung enthält zwei piezoelektrische Schwingungswandler 30, die mechanisch mit einer zylindrischen Sonotrode 32 gekoppelt sind. Die piezoelektrischen Schwingungswandler 30 greifen tangential am Umfang der Sonotrode 32 an, so dass deren durch die Doppelpfeile 34 angedeutete Linearschwingung in eine Torsions- oder Rotationsschwingung der Sonotrode 32 umgewandelt wird. Die beiden miteinander zu verbindenden Werkstücke 22, 4 (2) sind auf ein Aufnahmewerkzeug 38 angeordnet. Das Aufnahmewerkzeug 38 und die Sonotrode 32 werden nun mit zwischengelegten Werkstücken 22, 4 (2) durch Ausübung einer axialen Kraft F gegeneinander gedrückt und die Sonotrode 32 wird in eine Torsions- oder Drehschwingung mit hoher Schwingungsfrequenz (beispielsweise 20 kHz) versetzt. Durch die dabei erzeugte Reibungswärme werden die Werkstücke, im Beispiel das Kontaktelement 22 und das auf dem Trägersubstrat 4 befindliche Halbleiterbauelement 2 im Bereich der Kontaktzone 16 miteinander verschweißt.

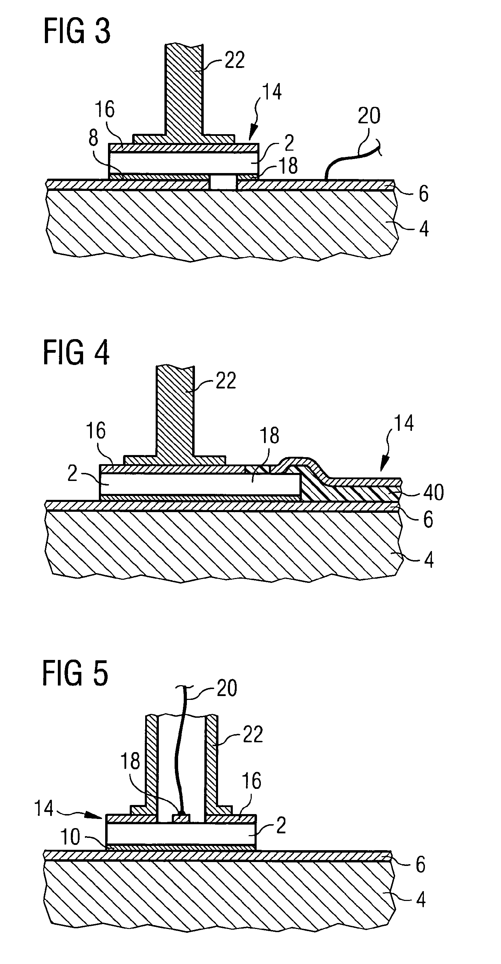

In der Ausführungsform gemäß FIG 3 befindet sich der Steueranschluss auf der Unterseite (Flachseite 8) des Halbleiterbauelements 2. Um die elektrische Trennung zwischen Lastanschluss und Steueranschluss zu ermöglichen, ist hierzu die metallische Schicht 6 des Trägersubstrates 4 entsprechend strukturiert. Zur Kontaktierung des Steueranschlusses ist an die metallische Schicht 6 des Trägersubstrats 4 ein Bonddraht 20 gebondet.

Im Ausführungsbeispiel gemäß FIG 4 ist die Oberseite des Halbleiterbauelementes 2 analog zum Ausführungsbeispiel gemäß FIG 1 mit einer metallischen Schicht 14 versehen, die in zwei voneinander getrennte Kontaktzonen 16 und 18 aufgeteilt ist. In diesem Ausführungsbeispiel wird die metallische Schicht 14 auf der Oberseite (Flachseite 12) des Halbleiterbauelements 2 durch ein Verfahren hergestellt, wie es aus der eingangs genannten WO 03/030247 A2 bekannt ist, und bei dem in einem der metallischen Beschichtung vorgelagerten Verfahrensschritt auf das aus Halbleiterbauelement 2 und Trägersubstrat 4 bestehende Bauteil eine Kunststofffolie 40 laminiert wird, die mit Öffnungen versehen wird und anschließend metallisch beschichtet wird, so dass an den Öffnungen ein elektrischer Kontakt zum Halbleiterbauelement 2 hergestellt wird.

Im Ausführungsbeispiel gemäß FIG 5 ist als Kontaktelement 22 ein hohlzylindrischer Kontaktstift vorgesehen, und die metallische Schicht 14 auf der Oberseite (Flachseite 12) des Halbleiterbauelements 2 ist derart strukturiert, dass die Kontaktzone 18 für den Steueranschluss innerhalb des hohlzylindrischen Kontaktelements 22 angeordnet und dort mit dem Bonddraht 20 kontaktiert ist, der im Inneren des Kontaktstiftes verläuft.

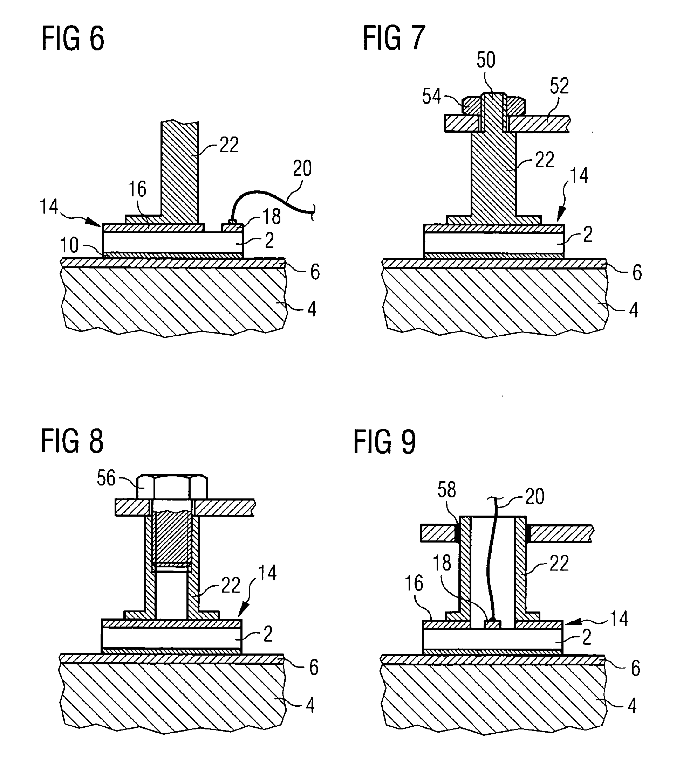

Im Ausführungsbeispiel gemäß FIG 6 ist als Kontaktelement 22 ein L-förmiger Anschlussbügel vorgesehen, der mit seinem kurzen Schenkel auf der Kontaktzone 16 des Halbleiterbauelementes 2 aufsitzt und mit diesem ebenfalls durch Reibschweißen verschweißt ist.

Die Befestigung des Kontaktelements 22 mit einem Anschlussleiter kann auf unterschiedliche Weise erfolgen. In FIG 7 ist beispielhaft aufgeführt, dass ein als vollzylindrischer Stift gestaltetes Kontaktelement 22 an seinem vom Halbleiterbauelement 2 abgewandten freien Ende einen Gewindebolzen 50 aufweist. Der Gewindebolzen 50 durchsetzt eine in einem Anschlussleiter 52 befindliche Öffnung, so dass der Anschlussleiter 52 mit einer Mutter 54 an einer den Gewindebolzen 50 umgebenden Schulter des Kontaktelements 22 fixiert werden kann.

In der alternativen Ausgestaltung gemäß FIG 8 ist ein hohlzylindrisches Kontaktelement 22 vorgesehen, das mit einem Innengewinde versehen ist, so dass ein ebenfalls mit einer Öffnung versehener Anschlussleiter 52 über eine Schraube 56 mechanisch am Kontaktelement 22 fixiert werden kann.

Alternativ hierzu ist es auch möglich, den Anschlussleiter 52 über eine Lötverbindung 58 mit dem Kontaktelement 22 zu verbinden, wie dies in FIG 9 anhand eines Ausführungsbeispiels mit einem hohlzylindrischen Kontaktelement 22 mit einem innenliegenden Steueranschluss dargestellt ist.

Alternativ zu den genannten Anschlussarten sind auch noch Quetsch- oder Pressverbindungen oder Schmelzschweißverbindungen möglich.

## Patentansprüche

1. Verfahren zum Herstellen eines Anschlusskontaktes an einem Halbleiterbauelement (2) für die Leistungselektronik, wird das Halbleiterbauelement (2) auf zumindest einer seiner Flachseiten (8, 12) mit einem Reibschweißverfahren mit einem metallischen Kontaktelement (22) verschweißt.

2. Verfahren nach Anspruch 1, bei dem das Halbleiterbauelement (2) mit einer seiner Flachseiten (8, 12) auf einem Trägersubstrat (4) angeordnet ist, und bei dem das metallische Kontaktelement (22) mit dem Halbleiterbauelement (2) auf seiner vom Trägersubstrat (4) abgewandten Flachseite (12) verschweißt wird.

3. Verfahren nach Anspruch 1 oder 2, bei dem als Kontaktelement (22) ein zylindrischer Kontaktstift vorgesehen ist, der eine ringförmig umlaufende Schulter (24) aufweist, mit der er auf das Halbleiterbauelement (2) aufgesetzt wird, und die mit einem Rotations-Reibschweißverfahren mit dem Halbleiterbauelement (2) verschweißt wird.

4. Verfahren nach Anspruch 3, bei dem der Kontaktstift hohlzylindrisch ist.

5. Verfahren nach einem der vorhergehenden Ansprüche, bei dem das Reibschweißverfahren ein Ultraschallschweißverfahren ist.

6. Verfahren nach einem der vorhergehenden Ansprüche, bei dem das Halbleiterbauelement (2) auf einem DCB-Trägersubstrat angeordnet und mit diesem verlötet ist.

7. Elektronisches Bauteil mit einem Halbleiterbauelement (2), das an zumindest einer seiner Flachseiten (8,12) mit einem als Anschlusskontakt vorgesehenen metallischen Kontaktelement (22) durch ein Reibschweißverfahren verschweißt ist.

8. Elektronisches Bauteil nach Anspruch 7, bei dem das Halbleiterbauelement (2) mit einer seiner Flachseiten (8, 12) auf einem Trägersubstrat (4) angeordnet ist, und bei dem das metallische Kontaktelement (22) mit dem Halbleiterbauelement (2) auf seiner vom Trägersubstrat (4) abgewandten Flachseite (12) verschweißt ist.

9. Elektronisches Bauteil nach Anspruch 7 oder 8, bei dem das Kontaktelement (22) ein zylindrischer Kontaktstift ist, der eine ringförmig umlaufende Schulter (24) aufweist, mit der er auf das Halbleiterbauelement (2) aufgesetzt und mit diesem durch ein Rotations-Reibschweißverfahren verschweißt ist.

10. Elektronisches Bauteil nach Anspruch 9, bei dem der Kontaktstift hohlzylindrisch ist.

11. Elektronisches Bauteil nach einem der Ansprüche 7 bis 10, bei dem das Halbleiterbauelement (21) auf einem DCB-Trägersubstrat angeordnet und mit diesem verlötet ist.
